(19) Europäisches Patentamt
European Patent Office
Office européen des brevets

(11) Publication number: **0 105 382**
**B1**

(12) # EUROPEAN PATENT SPECIFICATION

(45) Date of publication of patent specification: **07.01.87**

(51) Int. Cl.$^4$: **G 03 C 1/68,** G 03 C 5/00, G 03 C 5/24, C 08 F 2/50

(21) Application number: **83901104.6**

(22) Date of filing: **04.04.83**

(86) International application number: **PCT/JP83/00107**

(87) International publication number: **WO 83/03687 27.10.83 Gazette 83/25**

(54) **IMAGE-FORMING PHOTO-SENSITIVE MATERIAL.**

(30) Priority: **07.04.82 JP 57654/82**
**24.09.82 JP 167125/82**

(43) Date of publication of application: **18.04.84 Bulletin 84/16**

(45) Publication of the grant of the patent: **07.01.87 Bulletin 87/02**

(84) Designated Contracting States: **FR**

(56) References cited:
**DE-A-2 410 218**
**DE-A-2 525 673**
**JP-A-55 069 140**
**JP-A-55 094 903**
**JP-A-56 099 336**

**Chemical Abstracts, Vol. 92, No. 21, 26. May 1980 (26.05.80) (Fukuoka, Japan) T. Matsuo, Y. Aso, K. Kano, "Ber. Bunsenges. Phys. Chem. "Vol. 84, No. 2, P146 - 152 See Abstract No. 177585**

(73) Proprietor: **SONY CORPORATION**
**7-35 Kitashinagawa 6-Chome Shinagawa-ku**
**Tokyo 141 (JP)**

(72) Inventor: **ITO, Kengo**
**15-5, Nishioi-machi Sinagawa-ku**
**Tokyo 140 (JP)**

(74) Representative: **Cotter, Ivan John et al**
**D. YOUNG & CO. 10 Staple Inn**
**London WC1V 7RD (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

The invention relates to photosensitive imaging materials.

A known image-copying technique involves the use of a photosensitive material which exhibits a change in adhesive properties when subjected to light. Examples of documents disclosing this technique are US Patent Specifications Nos. US—A—3 549 367 and US—A—3 649 268. This technique is an extension of a photoengraving technique, and copying has conventionally been performed by a sequence of steps of exposing imagewise the photosensitive material to actinic radiation through an original film such as a halfone positive recorded by dot separation, e.g. according to a silver salt photographic technique, to cause a change in tackiness in the exposed areas, and dusting with a pigment. The photosensitive material used in this technique is constructed as a photosensitive film composed of a base film transparent to the actinic radiation and a photosensitive layer that is tacky at room temperature. The photosensitive layer of this photosensitive film is in turn composed of a uniform composition comprising a polymerisation initiator (hereinafter referred to as "the photopolymerisation initiator") for photosensitised polymerisation, a polymerisable or crosslinkable monomeric compound and a binder comprising a thermoplastic polymer. This photosensitive film has the characteristic of exhibiting a significant change in tackiness when exposed to actinic radiation such as ultraviolet rays or the like whose energy density is several $mJ/cm^2$ — 10 $mJ/cm^2$. This change in tackiness is due to the photopolymerisation initiator of the photosensitive layer being excited by the energy of the actinic radiation and a polymerisation or crosslinking reaction of the monomer being brought about, whereby the photosensive layer is hardened. And, for example, where imagewise exposure of the photosensitive film is performed through an original film such as a halftone positive by using an ultra-high pressure mercury lamp as an actinic radiation (ultraviolet radiation) source on condition that the actinic radiation intensity at the exposed surface is 0.2 $mW/cm^2$, the image-copying is achieved by several tens of seconds of exposure.

As described above, in the image-copying technique employing a photosensitive material which exhibits a change in tackiness when subjected to light, copying is conventionally performed indirectly by employing an original film recorded by dot separation. This is because, since this photosensitive material has almost no halftone reproducibility *per se*, it is necessary to convert the light intensity information of the original film into a monochromatic area. Therefore, when this photosensitive material is to be applied to a method of recording a light image directly from a photo-image generating device such as a cathode ray tube which emits ultraviolet rays, a fibre tube or the like, it is necessary to subject the photo-images to electrical area-converting treatment. As a result, a great loss in the amount of the actinic radiation is caused by, for example, attenuation by an optical system employed for image formation. Also, since the light intensity is small in these light image generating devices, an exposure time of several times $10^3$ hours is required for image recording. Therefore, in this case, it is difficult to obtain a practical photographic speed or resolving power.

Embodiments of the present invention described hereinbelow aim to provide a photosensitive imaging material in which the drawbacks of the conventionally known photosensitive films are improved and which has an increased photographic speed, i.e. photographic sensitivity, thereby enabling the imaging to take place in a relatively short time. The embodiments described below also aim to provide a photosensitive imaging material having halftone reproducibility *per se*.

Photosensitive imaging material according to this invention comprises, as a photopolymerisation initiator, an alloxazine derivative of the general formula:

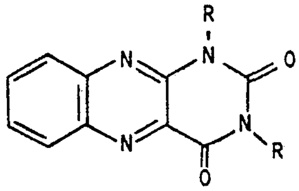

(I)

wherein each R, which may be the same as or different from the other, represents an alkyl group having 1 to 20 carbon atoms or a phenylalkyl group of the general formula

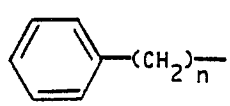

wherein n is an integer equal to 1 or more, together with a binder, a polymerisable tackifying monomer, and a tertiary amine, the amount of the alloxazine derivative being 0.01 to 15 parts by weight and the amount of the tertiary amine being 0.5 to 15 parts by weight, based on 100 parts by weight of the total of binder and monomer. By using such material the initiating reaction of photopolymerisation or crosslinking

of a polymerisable tackifying monomer is promoted, so that is is made possible to increase the photographic speed and photographic sensitivity. Further, and in accordance with another embodiment of the invention, the photosensitive imaging material is made into a photosensitive composite material comprising:

(a) a hardened layer formed by hardening a composition containing an alloxazine derivative represented by the general formula (I) set forth in claim 1 as a photopolymerisation initiator, a binder, and a polymerisable tackifying monomer, the amount of the alloxazine derivative being 0.01 to 15 parts by weight based on 100 parts by weight of the total of binder and monomer, and

(b) a photosensitive layer laminated on the hardened layer and containing an alloxazine derivative represented by the above general formula (I), a binder and a polymerisable tackifying monomer, the amount of the alloxazine derivative being 0.01 to 15 parts by weight based on 100 parts by weight of the total of binder and monomer. The hardening is preferably effected by irradiation with light, and the photosensitive layer (b) also contains a tertiary amine, the amount of the tertiary amine being 0.5 to 15 parts by weight, based on 100 parts by weight of the total of binder and monomer. Such material makes it possible to change the tackiness of the photosensitive layer depending on the exposure. Thus, halftone reproducibility is imparted to the photosensitive material *per se*, thereby enabling direct reproduction of photo-images from a photo-image generating source without area converting treatment.

The invention will now be further described, by way of illustrative and non-limiting example, with reference to the accompanying drawings, in which:

Figure 1 is a cross-sectional view of an example of a photosensitive film employing a photosensitive imaging material embodying this invention;

Figures 2A to 2C are cross-sectional views showing a developing procedure for the photosensitive film of Figure 1;

Figure 3 is a cross-sectional view of another example of a photosensitive film employing a photosensitive imaging material embodying this invention;

Figures 4A and 4B are cross-sectional views showing a procedure for preparing a photosensitive film employing a photosensitive imaging material embodying this invention;

Figure 5A and Figure 5B are cross-sectional views showing a developing procedure for the photosensitive film of Figure 4B;

Figures 6 to 9 are graphs showing photosensitive characteristics of the photosensitive films according to Examples of this invention and of Comparative Examples; and

Figure 10 is a cross-sectional view of a multicoloured print prepared by employing a photosensitive imaging material embodying this invention.

Preferred embodiments of the invention will now be described.

Photosensitive imaging materials embodying this invention and described hereinbelow comprise a polymerisable monomer for attaching a pigment or a colouring agent, a binder for making this polymerisable monomer into a film, and an alloxazine derivative functioning as a photopolymerisation initiator for the polymerisable monomer.

The alloxazine derivative employed is a light-absorbing species, which acts as a polymerisation initiator owing to a function of withdrawing hydrogen from other components of the photosensitive material, and has excellent compatibility in spectral properties with a light source. Further, since it is lipophilic, it has good compatibility with a hydrophobic compound used as the binder or the polymerisable monomer and is suitable for forming a uniform film. This alloxazine derivative is represented by the general formula set forth above.

In the R substituents of this alloxazine derivative, the number of the carbon atoms in the alkyl group is, as already stated, from 1 to 20 preferably from 2 to 16, and particularly from 4 to 12. Where the number of carbon atoms in the above alkyl group is too large, the compatibility with the binder used becomes poor, whereas an alloxazine derivative having no alkyl group in the R substituents is not suitable for use because of its low solubility in organic solvents. Further, since a solvent which can dissolve the alloxazine derivative will vary depending on the chain length of the alkyl group in the R substituents, the solvent may be appropriately selected according to the kind of the alloxazine derivative used.

The binder employed has film-forming properties and is colourless and transparent when made into a film. Examples of this binder include cellulose derivatives such as cellulose acetate and cellulose acetate butyrate, polyacrylic esters and polymethacrylic esters.

The polymerisable monomer for imparting tackiness to the photosensitive imaging material comprises a compound that has one or more, preferably two or more, acrylic or methacrylic double bonds in the molecule and that hardens by polymerisation or crosslinking when irradiated with light. Examples of the polymerisable monomer include alkyl esters or hydroxyalkyl esters of monofunctional (meth) acrylic acids, such as 2-ethylhexyl acrylate, 2-ethylhexyl methacrylate, 2-hydroxyethyl acrylate, 2-hydroxyethyl methacrylate, 2-hydroxypropyl acrylate and 2-hydroxypropyl methacrylate, difunctional (meth) acrylic esters such as diethylene glycol diacrylate, diethylene glycol dimethacrylate, 1,3-butanediol diacrylate, 1,3-butanediol dimethacrylate, 1,6-hexanediol diacrylate, 1,6-hexanediol dimethacrylate, neopentyl glycol diacrylate and neopentyl glycol dimethyacrylate, trifunctional (meth) acrylic esters such as trimethylolpropane triacrylate, trimethylolpropane trimethyacrylate, pentaerythritol triacrylate and pentaerythritol methacrylate, and polyfunctional (meth) acrylic esters such as dipentaerythritol hexaacrylate and

dipentaerythritol hexamethacrylate. Of these monomers, di- or higher-functional ones are preferred.

As an auxiliary chemical species for promoting the above-described polymerisation or crosslinking of the polymerisable monomer, it is effective to employ a tertiary amine by incorporating it in the photosensitive material. This tertiary amine may be, e.g., an aromatic-aliphatic tertiary amine, or an aliphatic tertiary amine, which preferably has a structure containing withdrawable hydrogen in the skeleton thereof. Useful aromatic-aliphatic tertiary amines may include, e.g. tribenzylamine; triphenethylamine, etc. Further, useful aliphatic tertiary amines may include, e.g. trihydroxyalkylamines such as trimethanolamine, triethanolamine, etc.; trialkylamines preferably having 5 to 12 carbon atoms in the alkyl residue, e.g., tri-n-pentylamine, tri-n-dodecylamine, etc.; triacyloxyamines, which are esters of trihydroxyalkylamines and fatty acids having 2 or more carbon atoms, such as triacetoxymethylamine, triacetoxyethylamine, tripropioxymethylamine, tripropioxyethylamine, etc.; and the like.

Tackiness is imparted to the photosensitive layer by mixing the above-mentioned binder with the above-mentioned polymerisable monomer. The mixing proportion is preferably appropriately selected within the range of about 10:1 to 1:10 by weight by taking the viscosity, tack strength, etc. into consideration. The amount of alloxazine derivative used is in the range of from about 0.01 to 15 parts by weight based on 100 parts by weight of the total amount of the above-mentioned binder and monomer. If the amount of this alloxazine is too small, the effect as the photopolymerisation initiator is unsatisfactory, and if it is too large the film obtained is likely to take on colour and is not preferred. Furthermore, the amount of the tertiary amine used is in the range of 0.5 to 15 parts by weight based on 100 parts by weight of the total amount of the above-mentioned binder and monomer. If the amount of the tertiary amine is too small, the effect cannot be expected, and too large an amount of the tertiary amine exceeds the solubility limit.

Further, depending on the case, for example, where the photosensitive material is taking on colour, it is preferably to incorporate in the photosensitive material a brightening agent which fluoresces in an emission band of about 400—480 nm and is of excellent compatibility with other components of the material. Useful brightening agents include anthracene derivatives, e.g. 9,10-dichloroanthracene; stilbene derivatives; quinolone derivatives; coumarin derivatives, e.g. 7-diethylamino-4-methylcoumarin; and oxazole derivatives.

A photosensitive imaging material embodying this invention and having the above-described composition may, as shown for example in Figure 1, be coated to a predetermined thickness on a base film 2 transparent to actinic radiation to form a film or photosensitive layer 3. The photosensitive layer 3 is covered with a cover film 4, whereby a photosensitive film 1 is fabricated.

Images can be transferred to the thus-obtained photosensitive film by changing the tackiness of the photosensitive layer by imagewise exposure to actinic radiation, and dusting with a pigment, etc., to visualise the image. Multiple colouring can be achieved by repeating this operation.

This transfer method will now be described with reference to Figures 2A to2C. In Figure 2A, an original film having light non-transmissive parts 5a and light transmissive parts 5b in a predetermined pattern, i.e. a tablet, is brought closely into contact with the photosensitive film 1 having the composition shown in Figure 1, and is irradiated with actinic radiation (mainly composed of ultraviolet rays) from above, thereby causing a change in tackiness between non-exposed areas 3a and exposed areas 3b corresponding, respectively, to the light non-transmissive parts and the light transmissive parts of the tablet. That is, in the exposed areas 3b, the polymerisable monomer of the photosensitive layer 3 proceeds with polymerisation or crosslinking to harden and, as a result, the tackiness is lost, whereas, on the non-exposed areas 3a, the tackiness is maintained because hardening does not take place. Thereafter, as shown in Figure 2B, the cover film 4 is removed, after which toner 6 is dusted on the photosensitive layer 3 so that, as shown in Figure 2C, the toner 6 adheres to the non-exposed parts 3a to form images. The production of multi-coloured images can be accomplished by further laminating photosensitive layers and repeating the steps of Figures 2A and 2B successively.

Further, a photosensitive imaging material made into a composite material comprising a hardened layer or layers (hereinafter referred to the "sensitising treating layer") made by using and hardening by irradiation with light the components of the above photosensitive material, and a photosensitive layer or layers laminated thereon, enables halftone reproduction of images. In this photosensitive composite material, the sensitising treating layer is obtained by hardening a composition comprising a binder, a polymerisable tackifying monomer, and an alloxazine derivative as a photopolymerisation initiator. The photosensitive layer contains a binder, a polymerisable tackifying monomer, an alloxazine derivative and preferably a tertiary amine. The alloxazine derivatives, binders and polymerisable monomers employed in the sensitising treating layer and photosensitive layer may be any of the above-described compounds employed in the above-described compositional ratios, and these components may be either the same compound or different from each other as between these two layers. Further, the above-described compounds may be employed as the tertiary amine contained in the photosensitive layer, and this may also be employed by incorporating it in the sensitising treatment layer.

Such a composite photosensitive imaging material may be made into a photosensitive film 11 having a construction, e.g., as shown in Figure 3. This photosensitive film 11 may be prepared as follows. Firstly, the above-mentioned components for the sensitising treating layer are dissolved in a suitable solvent, thereby preparing a uniform composition. This composition is coated on a base film 2a transparent to actinic

radiation, and the surface opposite to the base film 2a is covered with a similarly transparent cover sheet to form a sandwich-like film similar to Figure 1. This sandwich film is subjected to exposure uniformly over the entire surface thereof, thereby hardening the coating of the composition to give a sensitising treating layer 7. Thereafter, the above-mentioned components for the photosensitive layer are dissolved in a solvent, then this is coated on a base film 2b and covered with a cover sheet, thereby giving a sandwich film in which the photosensitive layer 3 is placed between the base film and the cover sheet. The cover sheets of these two sandwich films are peeled off and the photosensitive layer 3 is laminated on the sensitising treating layer 7 by means of, e.g., a press roller, so that a photosensitive film 11 as shown in Figure 3 can be obtained.

Transferring images to the photosensitive film thus obtained is performed by changing the tackiness of the photosensitive layer by imagewise exposure to actinic radiation as described below and subsequently dusting with a pigment or the like to visualise. Multiple colouring may be achieved by repeating this operation.

The principle of the imaging method utilising the change in tackiness caused by light basically resides in the photopolymerisation or crosslinking of the polymerisable monomer in the binder capable of forming a film, and where the reaction mechanism goes through a radical type process, it tends to undergo a reaction inhibitory effect due to oxygen molecules present in the atmosphere at the time of polymerisation or crosslinking. Photosensitive material embodying this invention is also liable to undergo such an inhibitory effect, but, by employing the alloxazine derivative, which is a light-absorbing species, as a photopolymerisation initiator, and, in particular, in the photosensitive layer, by employing it in combination with the tertiary amine, which is a sensitising species enhancing the radical type photopolymerisation initiating ability of the alloxazine derivatives, it is possible comparatively to blunt the inhibitory effect, at least that due to oxygen molecules dissolved in the composition. However, where a porous material such as paper is employed as a substrate to be an image receiver, the photosensitive composition is still not free from the inhibitory effect, due to oxygen which has permeated through the substrate.

In order to eliminate such an inhibitory effect and maintain the aforesaid sensitising effect on the tertiary amine and the quality of images, at least one surface of the substrate can be provided with an oxygen-impermeable film and a photosensitive composition comprising the aforesaid components can be laminated on this film.

The oxygen-impermeable film is preferably transparent or white, smooth, high in suppleness (flexibility) and excellent in adhesion to the sensitising treating layer. The film may, for example, comprise a polyacrylate (e.g., polymethyl methacrylate, polyethyl ethacrylate), an acrylic copolymer (e.g., polyvinyl acetate acrylate, polyvinyl acetate methacrylate, polyvinylidene chloride methacrylate, polymethacrylic acid methacrylate), polyvinyl acetate, a polyvinyl acetate copolymer (e.g. vinyl acetate-vinyl chloride copolymer), a polyvinyl acetal (e.g. polyvinyl butyral), a cellulose ester (e.g. cellulose acetate, cellulose acetate butyrate), etc.

A photosensitive imaging material comprising a substrate bearing the above-described oxygen-impermeable film may be made into a photosensitive film, for example as shown in Figures 4A and 4B. Firstly, an oxygen-impermeable film 9 is formed on one main surface of a substrate 8. In similar manner to that described above, a sandwich film of a sensitising treating layer is prepared. This sandwich film, after the cover sheet has been peeled off, is laminated on the film 9 of the substrate 8 such that the base film 2a is disposed on the top as shown in Figure 4A. Thereafter, the sensitising treating layer 7 is hardened by irradiation with actinic radiation, mainly composed of ultraviolet rays, from the side of the base film 2a. After the base film 2a is peeled off, the photosensitive layer 3 is laminated together with the base film 2b by using a press roller at room temperature, as shown in Figure 4B.

A method of transferring images to the thus-prepared photosensitive film will now be described with reference to Figures 5A and 5B. Firstly, as shown in Figure 5A, a tablet or a continuous tone positive original film for photography is brought into contact with the base film 2b as shown in Figure 5A. This original film has a light non-transmissive part 5a and a light transmissive part 5b and also an intermediate transmissive part 5c between them. When this original film is irradiated with actinic radiation from above as seen in Figure 5B, the tackiness changes as between a non-exposed area 3a, an exposed area 3b and an intermediate exposed area 3c corresponding to the light non-transmissive part 5a, the light transmissive part 5b and the intermediate light transmissive part 5c of the original film, respectively. That is, in the exposed area 3b, the polymerisable monomer of the photosensitive layer 3 proceeds with photopolymerisation or crosslinking and hardens, and, as a result, the tackiness is lost, whereas in the non-exposed area 3a, since hadening does not take place, the tackiness is large. Further, in the intermediate exposed area 3c, it is possible to change the tackiness according to the degree of exposure. As a result of changing the degree of polymerisation in the photosensitive layer 3 depending on the degree of this exposure, corresponding unevenness, i.e. a relief-like appearance, is generated on the photosensitive layer 3. Thereafter, the original film and the base film 2b are removed, and a toner 6 subsequently is dusted on the photosensitive layer 3. As shown in Figure 5B, since the toner 6 tends to adhere more to the less exposed area, it is possible to obtain images reproducing the continuous tone (half-tone) of the original film. The images have a somewhat relief-like appearance. Further, a protective film may be formed, for example, by a treatment in which a photosensitive layer having the same composition is laminated on top of the toner-adhered photosensitive layer and irradiated with light to harden it, whereby a glossy print of

good quality may be obtained. In addition, multi-coloured images may be obtained by repeating the laminating step shown in Figures 4A and 4B and the transferring step shown in Figures 5A and 5B alternately.

The alloxazine derivative having the above general formula may be synethesised, for example, as follows: o-Phenylenediamine and alloxan are reated and dehydrated at room temperature in an $N_2$ atmosphere to give alloxazine, and this alloxazine is reacted with an alkyl halide, e.g., an alkyl iodide in a solvent, e.g., N, N-dimethylformamide in the presence of potassium carbonate at room temperature, whereby a allozazine derivative in which the 1- and 3-positions have been substituted by alkyl may be obtained.

Synthesis Example 1

Synthesis of Alloxazine

An Erlenmayer flask was charged with 800 ml of water. Then, 3.5 g (30 mmoles) of o-phenylenediamine and 5.0 g (30 mmoles) of alloxan were added thereto and the mixture was stirred at room temperature in a nitrogen atomosphere for about 5 hours. The reaction mixture obtained was cooled with ice for 3 hours. Then, the yellow precipitate formed was filtered off and washed in ethanol and ether (50 ml, twice). This precipitate was recrystallised from an aqueous dimethylformamide solution to give pale yellow powdery crystals. Yield: 7.5 g (90%). M.p. 300°C or higher. IR spectrum: Values found ($cm^{-1}$); 1730, 1705 (C=O stretching), 1572 (Broad peak) —C=N (amide II band). Literature values ($cm^{-1}$): 1727, 1700, 1574.

The literature values are those of 7, 8-dimethylalloxazine (Lumichrome).

Elementary analysis value: $C_{10}N_4O_3H_8$

| | |
|---|---|
| Values found: | C 51.65%, H 3.51%, N 24.04% |
| Calculated values: | C 51.72%, H 3.47%, N 24.23% |

Synthesis Example 2

Synthesis of 1,3-Didodecylalloxazine

A round flask was charged with 1.2 g (5.4 mmoles) of alloxazine obtained in Synthesis Example 1 and 6.0 g (20 mmoles) of dodecyl iodide. About 160 ml of dimethyl-formamide and 4.0 g (29 mmoles) of potassium carbonate anhydride were added to the flask and the mixture was stirred at room temperature for 42 hours.

The reaction mixture obtained was filtered to remove the insolubles ($K_2CO_3$), and the solvent of the filtrate was distilled off under a reduced pressure to give a brown oily substance as a residue. This residue was dissolved in chloroform, transferred to an extraction funnel, and washed in a 0.05 N sodium hydroxide solution and water successively. After taking out the chloroform phase obtained, the solvent was concentrated under a reduced pressure, and a large amount of methanol was added, thereby separating a yellowish green precipitate. This precipitate was filtered out, washed in methanol, and thereafter recrystallised from a methanol-ethanol mixed solvent to five pale yellowish green powdery crystals. Yield: 2.5 g (85%). M.p. 105—108°C (non-corrected). Thin layer chromatography: confirmed to be a single substance by silica gel-chloroform. Rf value: 0.6.

Elementary analysis value: $C_{34}H_{54}N_4O_2$

| | |
|---|---|
| Values found: | C 74.04%, H 9.89%, N 10.12% |
| Calculated values: | C 74.14%, H 9.88%, N 10.17% |

Preparation Example 3

A mixture of 2 g (0.009 mole) of the alloxazine obtained in Synthesis Example 1 and 10 g (0.05 mole) of pentyl iodide was stirred in the presence of 4 g of potassium carbonate anhydride in N,N-dimethylformamide at room temperature for 40 hours. After removing the insolubles from the reaction mixture obained, the solvent was distilled off under a reduced pressure to give a brown oily substance as a residue. This residue was dissolved in chloroform, and washed in a 0.05 N sodium hydroxide aqueous solution and water successively. Then, after concentration and removing the solvent under a reduced pressure, a large amount of methanol was added, and the separated precipitate was recrystallised from a methanol-ethanol mixed solvent to give pale yellowish green powder crystals. Yield: 2.5 g. The crystals were easy to dissolve in most organic solvents, such as alcohol, chloroform, benzene, n-hexane, etc. Ultraviolet light absorption spectrum (in the dry coating in the photosensitive film): max 382 nm. There were shoulder absorptions in the vicinity of 370 and 400 nm.

This invention will now be described in more detail by way of various examples.

Example 1

A solution having the following composition was prepared:

| Composition | Weight (g) |
|---|---|
| 1,3-dipentylalloxazine (produced by Synthesis Example 3) | 0.1 |
| Triethylene glycol dimethacrylate | 5.8 |
| Polyethyl methacrylate | 8.0 |
| Trichloroethylene | 100.0 |

This mixture was stirred by means of a magnetic stirrer at room temperature for about an hour to form a solution. This solution was coated on a polyethylene terephthalate film base having a thickness of 0.03 mm so as to give a coating having a wet thickness of 0.3 mm. After drying this coating at 60°C, a polyethylene cover film having a thickness of 0.06 mm was laminated on this coating at room temperature to give a sandwich photosensitive film.

A tablet (manufactured by Eastman Kodak Co., density difference 0.3, 11 grades) was brought closely into contact with the film on its cover film side and exposed to light from a ultrahigh pressure mercury lamp (registered trademark "Jet Light" manufactured by Oak Seisakusho, Model UL—1300 Ms; Output 1 KW) for 30 seconds at an ultraviolet intensity of 2.8 $mW/cm^2$ at the exposed surface.

After completion of exposure, the cover film was peeled off and the exposed surface of the photosensitive layer was dusted with a black toner manufactured by E.I. Du Pont de Nemours and Company. Excess of toner was removed by an absorbing wadding, whereby it was found that the toner had adhered only to the area where the exposure had been insufficient while it had not adhered at all to the area corresponding to Grade 1 of the tablet (transmittance 89.13%).

Example 2

A solution having the following composition was prepared:

| Composition | Weight (g) |
|---|---|
| 1,3-dipentylalloxazine (prepared by Synthesis Example 3) | 0.1 |
| Triethanolamine | 0.3 |
| Triethylene glycol dimethacrylate | 6.0 |
| Polymethyl methacrylate | 8.0 |
| Trichloroethylene | 100.0 |

Using this mixture, a sandwich photosensitive film was prepared in the same manner as in Example 1. After this photosensitive film was exposed to light and developed in the same manner as in Example 1, the toner did not adhere to the area corresponding to Grades 1—6 of the tablet (transmittance 2.82%). Further, the photosensitivity of this photosensitive film was about $2^5 = 32$ times as high as that of the photosensitive film of Example 1. As a result, it was found that the photosensitivity increases by a remarkable extent by incorporating in the light curing composition described in Example 1 a tertiary amine capable of generating a free radical upon photochemical reaction with an alloxazine light exciting species.

Example 3

A solution having the following composition was prepared:

| Composition | Weight (g) |
|---|---|
| 1,3-dipentylalloaxazine (prepared by Synthesis Example 3) | 0.02 |
| Tribenzylamine | 2.0 |
| Triethylene glycol dimethacrylate | 6.0 |
| Polymethyl methacrylate | 8.0 |
| Trichloroethylene | 100.0 |

This mixture was treated in the same manner as in Example 1 to give a sandwich film. After peeling off the cover film, the coating on the base film was heat pressed onto a chrome coated paper sheet (white, designated by E.I. Du Pont de Nemours and Company) at 90°C by using a heat press roller. Then, a tablet was brought closely into contact with the base film and exposed to light under the same conditions as in Example 1 for 30 seconds. Thereafter, the base film was peeled off, and and a developing treatment was given to the surface of the photosensitive layer remaining on the chrome coated paper sheet. It was found that the toner had not adhered to the area corresponding to Grades 1—8 (Transmittance 0.71%). Therefore, the photosensitivity of this film was about $2^7$ = 128 times as high as that of Example 1. As a result, it was found that among the tertiary amines, in particular, tribenzylamine is effective in respect of compatibility and sensitivity. Further, it was found that this film shows significant photosensitivity when subjected to 0.6 mJ/$cm^2$ in ultraviolet energy density.

Example 4

A solution having the following composition was prepared:

| Composition | Weight (g) |
|---|---|
| 1,3-dipentylalloxazine (prepared by Synthesis Example 3) | 0.01 |
| Tribenzylamine | 2.0 |
| 9.10-dichloroanthracene | 0.1 |
| Triethylene glycol dimethacrylate | 6.0 |
| Polymethyl methacrylate | 8.0 |
| Trichloroethylene | 100.0 |

This mixture was treated similarly as in Example 1 to give a sandwich photosensitive film. Then, the photosensitive layer was hot pressed on a chrome coated paper sheet in the same manner as in Example 3. A colour-separated halftone positive film was brought closely into contact with the above base film and then exposed to light from the same light source as employed in Example 1 at the ultraviolet intensity at the exposed surface of 2.8 mW/$cm^2$ for 0.5 second.

After development was effected similarly as in Example 3, a photosensitive layer was further laminated on this layer, to protect the surface from the toner, and exposed to light from the base film side for 0.3 second. Then, the base film was peeled off to give a glossy print of good quality. Although the employed photosensitive layer containing the alloxazine derivative gives a somewhat pale yellowish green image colouring, it is possible to obtain images even better in quality by employing, as a brightening agent, an organic fluorescent substance emanating fluorescence in the blue light wavelength region in the photosensitive layer.

Example 5

A solution having the following composition was prepared:

| Composition | Weight (g) |
|---|---|
| 1,3-dipentylalloxazine (prepared by Synthesis Example 3) | 0.02 |
| Tri-n-dodecylamine | 1.00 |
| Triethylene glycol dimethacrylate | 6.00 |
| Polymethyl methacrylate | 8.00 |
| Trichloroethylene | 100.0 |

This mixture was treated similarly as in Examples 1 to 4 described above to form a film. After exposed to light at 2.8 $mW/cm^2$ for 30 seconds, the film was developed. The toner had not adhered at all to the region corresponding to Grade 1 (T=89.13%) of the tablet. The photographic sensitivity of this film was several times higher than in the case of 1,3-dipentylalloxazine alone.

Example 6

A solution having the following composition was prepared:

| Composition | Weight (g) |
|---|---|
| 1,3-dipentylalloxazine (prepared according to Synthesis Examples 1 and 2 or 2) | 0.025 |
| Tribenzylamine | 0.90 |
| 9,10-dichloroanthracene | 0.025 |
| Triethylene glycol dimethacrylate | 7.0 |
| Polymethyl methacrylate | 8.0 |
| Trichloroethylene | 100.0 |

This mixture was made into a film in the same manner as above, and it photosensitive layer was hot pressed to a chrome-coated paper sheet. A tablet was brought closely into contact with the base film of this film and exposed to light, and the toner did not adhere to the region corresponding to Grades 1—4 (T = 89.13—11.22%) of the tablet.

Example 7 and Comparative Example 1

A solution having the following composition was prepared:

| Composition | Weight (g) |
|---|---|
| 1,3-dipentylalloxazine (prepared by Synthesis Example 3) | 0.02 |
| Triethanolamine | 0.5 |
| Pentaerythritol triacrylate | 3.0 |
| Cellulose acetate butyrate | 5.0 |
| Methyl ethyl ketone | 50.0 |

This mixture was stirred at room temperature, using a magnetic stirrer, for about an hour and made into a solution. This solution was coated on a polyethylene terephtalate base film having a thickness of 0.03 mm so as to give a wet thickness of 0.3 mm. The coating was dried at 60°C, and a polypropylene cover film having a thickness of 0.06 mm was laminated on this coating to give a sandwich photosensitive film.

As Comparative Example 1, a solution having the above composition except for not containing triethanolamine was prepared.

On their cover film sides these sandwich films were brought closely into contact with tablets (manufactured by Eastman Kodak Co., Density difference 0.3, 11 grades), and each was exposed to light from an ultra-high pressure mercury lamp for a certain time. After completion of exposure, the polyethylene terephthalate base film was peeled off from each sandwich film, so that each photosensitive layer remained in all the amount on the cover sheet.

Thereafter, a black toner (manufactured by E. I. Du Pont de Nemours and Company) was dusted on the exposed surface of the photosensitive layer, and excess toner was removed with absorbent wadding. The film of Example 7 showed a fluctuation in the amount of the remaining toner in a wider exposure range as compared with the film of Comparative Example 1 and, moreover, the amount of the remaining toner was reduced almost in proportion to the logarithm of the exposure. That is, with the film of Example 7, the amount of the remaining toner was reduced continuously in accordance with the reduction of the transmittance of the tablet. Further, photosensitivity characteristic curves obtained by plotting the relationship between the optical density (transmission density) of each film and the logarithm of the exposure were as shown in Figure 6. From the above results, it may be concluded that the use of the film of Example 7 will be sufficient for reproducing or copying a continuous tone positive film original for ordinary photography having a density difference of 2.0 (transmittance 1—100%).

## Example 8 and Comparative Example 2

A solution having the following composition was prepared:

| Composition | Weight (g) |
|---|---|
| 1,3-dipentylalloxazine (prepared by Synthesis Example 3) | 0.02 |
| Tribenzylamine | 2.0 |
| Triethylene glycol dimethacrylate | 6.0 |
| Polymethyl methacrylate | 8.0 |
| Trichloroethylene | 100.0 |

Using this mixture, and proceeding in a similar manner to that set forth in Example 7, a photosensitive film was prepared.

Also, as Comparative Example 2, a photosensitive film was prepared similarly using a solution having the above composition except that the content of tribenzylamine was 0.3 g.

Next, these films were exposed to light, and each of the polyethylene terephthalate base films was peeled off, so that each photosensitive layer remained in all the amount on the cover sheet.

Then, each of the exposed surfaces of the photosensitive layers was subjected to development in similar manner to Example 7. The photosensitivity characteristic curves of these films are shown in Figure 7.

From Figure 7, it was concluded that the photosensitive film of Comparative Example 2 containing the tribenzylamine in only a small amount was remarkably inferior in photosensitive characteristics to Example 8 containing the tribenzylamine in a larger amount.

Example 9 and Comparative Example 3

Using a solution having the following composition by weight, and using similar procedures to those of Example 7, a sandwich photosensitive film was prepared. The wet coating of this film had a thickness of 0.15 mm.

| Composition | Weight (g) |
|---|---|
| 1,3-dipentylalloxazine (prepared according to Synthesis Examples 1 and 2 or 2) | 0.015 |
| 9,10-dichloroanthracene | 0.025 |
| Triethylene glycol dimethacrylate | 7.0 |
| Polymethacrylate | 8.0 |
| Trichloroethylene | 150.0 |

The sandwich film obtained was subjected to uniform exposure to light over an entire surface on the cover sheet side from a light source of a mercury lamp and excess exposure was effected to harden it, thereby preparing a sensitising treating layer.

Then, the cover sheet of this sandwich film was peeled off, and a photosensitive layer having the same composition as the sensitising treating layer was laminated on the exposed surface of the sensitising treating layer by means of a press roller. In such a way, a photosensitive film having the construction shown in Figure 3 was obtained.

As a layer for imaging, the upper photosensitive layer of this photosensitive film was exposed to light through a tablet and, after the uppermost base film was peeled off, developing was performed. The photosensitive characteristic curve of this film is shown in Figure 8.

As Comparative Example 3, a photosensitive film in which a photosensitising treating layer was not formed was prepared, and exposure and developing were performed for the film. The photosensitivity characteristic curve of this film is shown in Figure 8.

Example 10

Using a solution having the following composition by weight, and using similar procedures to those of Example 7, a sandwich film was prepared. Further, in similar manner to that set forth in Example 9, a photosensitive film was prepared. With this photosensitive film, a sensitising effect of $2^3$ to $2^4$ times was observed, and the α value (the gradient of the photosensitivity characteristic curve) was reduced to ½ or less.

| Composition | Weight (g) |
|---|---|
| 1,3-dibenzylalloxazine (prepared according to Synthesis Examples 1 and 2 or 2) | 0.015 |
| 9,10-dichloroanthracene | 0.025 |
| Tribenzylamine | 0.9 |
| Triethylene glycol dimethacrylate | 7.0 |
| Polymethyl methacrylate | 8.0 |
| Trichloroethylene | 150.0 |

Example 11

A resin solution having the following composition was coated on the even surface of a mirror coated paper sheet by using an applicator for paint coating (wet coating thickness of 0.15 mm), and dried at 50°C for 30 minutes, thereby preparing a surface treated paper sheet as an image receiver.

| Composition | Weight (g) |
|---|---|
| Polymethyl methacrylate | 10 |
| Triethylene glycol diacetate | 4 |
| Trichloroethylene | 150 |

Then, using a solution of the composition mentioned in Example 10, a sandwich film was prepared. The cover film of this film was peeled off, and a sensitising treating layer was laminated on the resin-coated surface of the above-described image receiver, with its base film disposed on top as shown in Figure 4A, by means of a press roller at room temperature. Then, exposure was performed for 10 seconds on the base film side by using an ultra-high pressure mercury lamp under a condition that the ultraviolet intensity on the exposed surface was 2.4 mW/cm$^2$, and the base film was peeled off. Further, as shown in Figure 4B, a photosensitive layer having the same composition as the sensitising treating layer was laminated on the exposed surface of the sensitising treating layer by means of a press roller. A tablet or a continuous tone positive original film for photography was brought closely into contact with the uppermost base film and exposed at the same ultraviolet intensity as above for 4 seconds.

Then, after the base film was peeled off, the exposed surface of the photosensitive layer was subjected to development similarly as in Example 7 and as shown in Figures 5A and 5B. On this layer was further laminated a photosensitive layer having the same composition as above, and this layer was exposed to light on the base film side for 10 seconds to form a protective layer. Thereafter, the base film was peeled off to give a glossy monochromatic print of good quality having a somewhat relief-like appearance. The photosensitivity characteristic curve of the print obtained is shown in Figure 9.

Example 12

A resin coating of the same composition as in Example 11 was formed on an even side surface of an art paper sheet and this surface-treated paper was used as an image receiver.

Next, using a sandwich photosensitive film having the same composition as in Example 10 and using the procedures described with reference to Figures 4A to 5B, the lamination, exposure and development of the photosensitive layers and the sensitising treating layers were repeated, using colour-separated continuous tone positive original films for photography. The form (trichromatic) and construction of this print are shown in Figure 10 and Table 1.

TABLE 1

| Positive Original | Toner for Development | Exposure Time | Layer | Legend in Fig. 10 |
|---|---|---|---|---|
| — | — | 10 sec. | Sensitising Treating Layer | 7a |
| Blue (B) | Yellow (Y) | 4 sec. | Photosensitive Layer | 3a |
| — | — | 10 sec. | Sensitising Treating Layer | 7b |
| Green (G) | Magenta (M) | 4 sec. | Photosensitive Layer | 3b |
| — | — | 10 sec. | Sensitising Treating Layer | 7c |
| Red (R) | Cyan (C) | 4 sec. | Photosensitive Layer | 3c |
| — | — | 10 sec. | Protective Layer | 10 |

Standard colour pigments designated by E.I. Du Pont de Nemours and Company were pulverised and used as the toners. If the black density of the image is insufficient, it is sufficient further to add a step of forming a black plate.

Further, a protective layer was formed in similar manner to Example 11, whereby a glossy multi-coloured print of good quality having a somewhat relief-like appearance was obtained.

Example 13

Where the tackiness of the photosensitive layer at room temperature is relatively high, that is where the content of the polymerisable monomer is relatively large, it is sufficient for only the lowest layer to be the sensitising treating layer, and by repeating lamination and imagewise exposure of each photosensitive layer alone, multiple colouring is possible.

A resinous film was formed on the even surface of a vinyl coated paper sheet for printing similarly as in Example 11, and this was used as an image receiver. Thereafter, using a solution having the following composition and using the same procedure as in Example 7 (except that the wet coating thickness was 0.15 mm), a sandwich film for a sensitising treating layer was obtained, and this was laminated on the above image receiver as shown in Figure 4B.

| Composition | Weight (g) |
|---|---|
| 1,3-dihexadecylalloxazine (prepared according to Synthesis Example 2) | 0.01 |
| 9,10-dichloroanthracene | 0.03 |
| Tribenzylamine | 2.10 |
| Triethylene glycol dimethacrylate | 14.0 |
| Polymethyl methacrylate | 8.0 |
| Trichloroethylene | 150.0 |

By repeating the procedure described with reference to Figure 4B, as photosensitive layer was laminated on the sensitizing treating layer. Further, a protective layer was formed in similar manner to Example 11, whereby a glossy multi-coloured print of good quality and rich in relief-like appearance was obtained. The constitution of this multi-coloured print is shown in Table 2.

TABLE 2

| Positive Original | Toner for Development | Exposure Time | Layer |
|---|---|---|---|
| — | — | 20 sec. | Sensitising Treating Layer |
| Blue (B) | Yellow (Y) | 15 sec. | Photosensitive Layer |
| Green (G) | Magenta (M) | 15 sec. | " |
| Red (R) | Cyan (C) | 15 sec. | " |
| — | — | 20 sec. | Protective Layer |

By employing imaging materials embodying this invention, it has now been made possible to obtain a practical photographic speed or resolving power, and further, to perform halftone (continuous tone) reproduction comparable to silver salt photography. Thus, similarly as with silver salt type photographic materials, it has now been made possible to record or reproduce a light image on a projected image of an actinic radiation (ultraviolet light) generating source such as a cathode ray tube, as fibre tube, a Braun tube, etc., directly onto paper without a halftone monochromatic area converting operation.

**Claims**

1. A photosensitive imaging material that exhibits a change in adhesive properties when subjected to light comprising a photopolymerisation initiator, a binder and a polymerisable tackifying monomer, characterised in that the photopolymerisation initiator is an alloxazine derivative represented by the general formula:

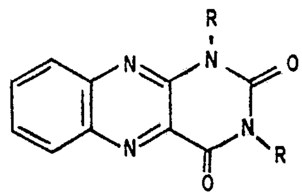

(I)

wherein each R, which may be the same as or different from the other, represents an alkyl group having 1 to 20 carbon atoms or a phenylalkyl group of the general formula

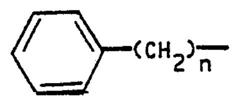

wherein n represents an integer of 1 or more, the material further comprises a tertiary amine, the amount of the alloxazine derivative is 0.01 to 15 parts by weight and the amount of the tertiary amine is 0.5 to 15 parts by weight, based on 100 parts by weight of the total of binder and monomer.

2. A composite photosensitive imaging material that exhibits a change in adhesive properties when subjected to light characterised in that it comprises:

(a) a hardened layer formed by hardening a composition containing an alloxazine derivative represented by the general formula (I) set forth in claim 1 as a photopolymerisation initiator, a binder, and a polymerisable tackifying monomer, the amount of the alloxazine derivative being 0.01 to 15 parts by weight based on 100 parts by weight of the total of binder and monomer, and

(b) a photosensitive layer laminated on the hardened layer and containing an alloxazine derivative represented by the above general formula (I), a binder and a polymerisable tackifying monomer, the amount of the alloxazine derivative being 0.01 to 15 parts by weight based on 100 parts by weight of the total of binder and monomer.

3. A photosensitive imaging material according to claim 2, in which the photosensitive layer (b) also contains a tertiary amine, the amount of the tertiary amine being 0.5 to 15 parts by weight, based on 100 parts by weight of the total of binder and monomer.

4. A photosensitive imaging material according to any one of claims 1 to 3 containing a brightening agent.

5. A photosensitive imaging material according to any one of claims 1 to 3, comprising a substrate bearing an oxygen-impermeable film on at least one surface thereof, wherein either the photosensitive composition, or the hardened layer and the photosensitive layer, is/are laminated on the film.

6. A photosensitive imaging material according to claim 5, wherein the substrate is composed of a porous material such as paper.

7. A photosensitive imaging material according to claim 5, wherein the film is composed of a polyacrylate, an acrylic copolymer, polyvinyl acetate, a polyvinyl acetate copolymer, polyvinyl acetal or a cellulose ester.

8. A photosensitive imaging material according to claim 3, wherein the hardened layer contains a tertiary amine.

9. A photosensitive imaging material according to any one of claims 2, 3 and 8, wherein the tertiary amine is an aromatic tertiary amine.

10. A photosensitive imaging material according to any one of claims 2, 3 and 8, wherein the tertiary amine is an aliphatic tertiary amine.

11. A photosensitive imaging material according to claim 9, wherein the tertiary amine is tribenzylamine or triphenethylamine.

12. A photosensitive imaging material according to claim 10, wherein the tertiary amine is a trialkylamine, a trihydroxyalkylamine or a triacyloxyamine.

13. A photosensitive imaging material according to any one of claims 1 to 12, wherein the alloxazine derivative is 1,3-dipentyl-alloxazine.

14. A photosensitive imaging material according to any one of claims 1 to 12, wherein the alloxazine derivative is 1,3-didodecyl-alloxazine.

15. A photosensitive imaging material according to any one of claims 1 to 12, wherein the alloxazine derivative is 1,3-dibenzyl-alloxazine.

16. A photosensitive imaging material according to any one of claims 1 to 12, wherein the alloxazine derivative is 1,3-dihexadecyl-alloxazine.

17. A photosensitive imaging material according to any one of the preceding claims, wherein the mixing ratio of the binder to the polymerisable tackifying monomer is in the range of from 10:1 to 1:10 by weight.

18. A photosensitive imaging material according to any one of the preceding claims, wherein the binder is a cellulose derivative, a polyacrylic ester or a polymethacrylic ester.

19. A photosensitive imaging material according to any one of the preceding claims, wherein the polymerisable tackifying monomer is a compound having an acrylic or methacrylic double bond.

20. A photosensitive imaging material according to claim 19, wherein the polymerisable tackifying monomer is a compound having two or more acrylic or methacrylic double bonds in the molecule.

**Patentansprüche**

1. Photoempfindliches bilderzeugendes Material, welches ein Änderung der Klebeeigenschaften bei Lichteinwirkung zeigt, umfassend einen Photopolymerisations- Initiator, ein Bindemittel und ein polymerisierbares klebrigmachendes Monomer, dadurch gekennzeichnet, daß der Photopolymerisations- Initiator ein Alloxazin- Derivat der allgemeinen Formel

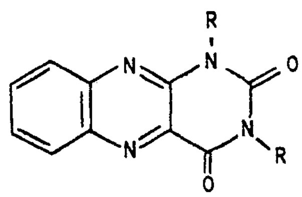

(I)

ist, in der jedes R, welches gleich oder verschieden voneinander sein kann, steht für eine Alkylgruppe mit 1 bis 20 C- Atomen oder eine Phenylalkylgruppe der allgemeinen Formel

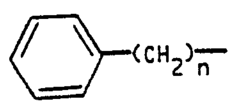

worin n eine ganze Zahl von 1 oder mehr ist, und daß das Material ferner ein tertiäres Amin enthält, wobei die Menge des Alloxazin- Derivats 0,01 bis 15 Gewichtsteile und die Menge des tertiären Amins 0,5 bis 15 gewichtsteile, bezogen auf 100 gewichtsteile vom Bindemittel und Monomer zusammen, betragen.

2. Photoempfindliches bilderzeugendes Verbundmaterial, welches ein Änderung der Klebeeigenschaften bei Lichteinwirkung zeigt, dadurch gekennzeichnet, daß es besteht aus:

(a) einer gehärteten Schicht, die durch Härten einer Mischung mit einem Gehalt an einem Alloxazin — Derivat der allgemeinen Formel (I) nach Anspruch 1 als Photopolymerisations- Initiator, einem Bindemittel und einem polymerisierbaren klebrigmachenden Monomer, wobei die Menge des Alloxazin- Derivats 0,01 bis 15 Gewichtsteile je 100 Gewichtsteile vom Bindemittel und Monomer zusammen beträgt, erhalten worden ist, und

(b) einer photoempfindlichen Schicht, welche mit der gehärteten Schicht laminiert ist und ein Alloxazin- Derivat der allgemeinen Formel (I), ein Bindemittel und ein klebrigmachen- des Monomer enthält, wobei die Menge des Alloxazin- Derivats 0,01 bis 15 Gewichtsteile, bezogen auf 100 Gewichtsteile vom Bindemittel und Monomer zusammen, beträgt.

3. Photoempfindliches bilderzeugendes Material nach Anspruch 2, wobei die photoempfindliche Schicht (b) außerdem noch ein tertiäres Amin enthält und dessen Menge 0,5 bis 15 Gewichtsteile, bezogen auf 100 Gewichtsteile vom Bindemittel und Monomer zusammen, ist.

4. Photoempfindliches bilderzeugendes Material nach einem jeden der Ansprüche 1 bis 3, enthaltend ein Aufhellungsmittel.

5. Photoempfindliches bilderzeugendes Material nach einem jeden der Ansprüche 1 bis 3, bestehend aus einem Substrat, das einen sauerstoff- undurchlässigen Film auf wenigstens einer Oberfläche trägt, und wobei entweder die photoempfindliche Mischung oder die gehärtete Schicht und die photoempfindliche Schicht auf den film laminiert ist bzw. sind.

6. Photoempfindliches bilderzeugendes Material nach Anspruch 5, wobei das Substrat aus einem porösen Material, wie Papier, besteht.

7. Photoempfindliches bilderzeugendes Material nach Anspruch 5, wobei der film aus einem Polyacrylat, einem Acrylsäurecopolymer, Polyvinylacetat, einem Polyvinylacetatcopolymer, Polyvinylacetal oder einem Celluloseester besteht.

8. Photoempfindliches bilderzeugendes Material nach Anspruch 3, worin die gehärtete Schicht ein tertiäres Amin enthält.

9. Photoempfindliches bilderzeugende Material nach einem jeden der Ansprüche 2, 3 und 8, worin das tertiäre Amin ein aromatisches tertiäres Amin ist.

10. Photoempfindliches bilderzeugendes Material nach einem jeden der Ansprüche 2, 3 und 8, worin das tertiäre Amin ein aliphatisches tertiäres Amin ist.

11. Photoempfindliches bilderzeugendes Material nach Anspruch 9, worin das tertiäre Amin Tribenzylamin oder Triphenethylamin ist.

12. Photoempfindliches bilderzeugendes Material nach Anspruch 10, worin das tertiäre Amin ein Trialkylamin, ein Trihydroxyalkylamin oder ein Triacyloxyamin ist.

13. Photoempfindliches bilderzeugendes Material nach einem jeden der Ansprüche 1 bis 12, worin das Alloxazin- Derivat 1,3-Dipentylalloxazin ist.

14. Photoempfindliches bilderzeugendes Material nach einem jeden der Ansprüche 1 bis 12, worin das Alloxazin-Derivat 1,3- Didodecylalloxazin ist.

15. Photoempfindliches bilderzeugendes Material nach einem jeden der Ansprüche 1 bis 12, worin das Alloxazin-Derivat 1,3-Dibenzylalloxazin ist.

16. Photoempfindliches bilderzeugendes Material nach einem jeden der Ansprüche 1 bis 12, worin das Alloxazin-Derivat 1,3- Dihexadecylalloxazin ist.

17. Photoempfindliches bilderzeugendes Material nach einem jeden der vorangehenden Ansprüche, worin das Mischungsverhältnis des Bindemittels zu dem polymerisierbaren klebrigmachenden Monomer in dem Bereich von 10:1 bis 1:10 liegt.

18. Photoempfindliches bilderzeugendes Material nach einem jeden der vorangehenden Ansprüche, worin das Bindemittel ein Cellulosederivat, ein Polyacrylsäureester oder ein Polymethacrylsäureester ist.

19. Photoempfindliches bilderzeugendes Material nach einem jeden der vorangehenden Ansprüche, worin das polymerisierbare klebrigmachende Monomer eine Verbindung mit einer Acryl- oder Methacryl-Doppelbindung ist.

20. Photoempfindliches bilderzeugendes Material nach Anspruch 19, worin das polymerisierbare klebrigmachende Monomer eine Verbindung mit zwei oder mehr Acryl- oder Methacryl- Doppelbindungen im Molekul ist.

**Revendications**

1. Matériau photosensible de formation d'image qui présente une variation des propriétés d'adhésivité lorsqu'il est soumis à la lumière, comprenant un inducteur de photopolymérisation, un liant et un monomère adhésif polymérisable, caractérisé en ce que l'inducteur de photopolymérisation est un dérivé d'alloxazine représenté par la formula générale

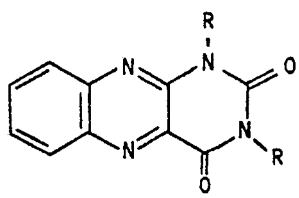

(I)

dans laquelle les restes R peuvent être identiques ou différents et représentent chacun un groupe alkyle en $C_1$—$C_{20}$ ou un groupe phénylalkyle de formule générale

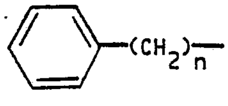

dans laquelle n représente un entier égal à 1 ou plus, le matériau comprenant en outre une amine tertiaire, la quantité du dérivé d'alloxazine est de 0,01 à 15 parties en poids et la quantité de l'amine tertiaire est de 0,5 à 15 parties en poids, pour 100 parties en poids du total du liant et du monomère.

2. Matériau photosensible composite de formation d'image qui présente une variation des propriétés d'adhésivité lorsqu'il est soumis à la lumière, caractérisé en ce qu'il comprend

(a) une couche durcie formée par durcissement d'une composition contenant un dérivé d'alloxazine représenté par la formule (I) indiquée à la revendication 1 comme inducteur de photopolymérisation, un liant et un monomère adhésif polymérisable, la quantité du dérivé d'alloxazine étant de 0,01 à 15 parties en poids pour 100 parties en poids du total du liant et du monomère, et

(b) une couche photosensible stratifiée sur la couche durcie et contenant un dérivé d'alloxazine représenté par al formule générale (I) ci-dessus, un liant et un monomère adhésif polymérisable, la quantité du dérivé d'alloxazine étant de 0,01 à 15 parties en poids pour 100 parties en poids du total du liant et du monomère.

3. Matériau photosensible de formation d'image selon la revendication 2, dans lequel la couche

photosensible (b) contient également une amine tertiaire, la quantité de l'amine tertiaire étant de 0,05 à 15 parties en poids pour 100 parties en poids du total du liant et du monomère.

4. Matériau photosensible de formation d'image selon l'une quelconque des revendications 1 à 3, contenant un agent azurant.

5. Matériau photosensible de formation d'image selon l'une quelconque des revendications 1 à 3, comprenant un support portant un film imperméable à l'oxygène sur au moins l'une de ses faces, dans lequel soit la composition photosensible, soit la couche durcie et la couche photosensible est ou sont stratifiées sur le film.

6. Matériau photosensible de formation d'image selon la revendication 5, dans lequel le support est composé d'un matériau poreux comme la papier.

7. Matériau photosensible de formation d'image selon la revendication 5, dans lequel le film est composé d'un polyacrylate, d'un copolymère acrylique, d'acétate de polyvinyle, d'un copolymère d'acétate de polyvinyle, de polyvinylacétal ou d'un ester cellulosique.

8. Matériau photosensible de formation d'image selon la revendication 3, dans lequel la couche durcie contient une amine tertiaire.

9. Matériau photosensible de formation d'image selon l'une quelconque des revendications 2, 3 et 8, dans lequel l'amine tertiaire est une amine tertiaire aromatique.

10. Matériau photosensible de formation d'image selon l'une quelconque des revendications 2, 3 et 8, dans lequel l'amine tertiaire est une amine tertiaire aliphatique.

11. Matériau photosensible de formation d'image selon la revendication 9, dans lequel l'amine tertiaire est la tribenzylamine ou la triphénéthylamine.

12. Matériau photosensible de formation d'image selon la revendication 10, dans lequel l'amine tertiaire est une trialkylamine, une trihydroxyalkylamine ou une triacyloxy[alkyl]amine.

13. Matériau photosensible de selon l'une quelconque des revendications 1 à 12, dans lequel le dérivé d'alloxazine est la 1,3-dipentyl-alloxazine.

14. Matériau photosensible selon l'une quelconque des revendications 1 à 12, dans lequel le dérivé d'alloxazine est la 1,3-didodécylalloxazine.

15. Matériau photosensible selon l'une quelconque des revendications 1 à 12, dans lequel le dérivé d'alloxazine est la 1,3-dibenzyl-alloxazine.

16. Matériau photosensible selon l'une quelconque des revendications 1 à 12, dans lequel le dérivé d'alloxazine est la 1,3-dihexadécyl-alloxazine.

17. Matériau photosensible de formation d'image selon l'une quelconque des revendications précédentes, dans lequel le rapport de mélange du liant au monomère adhésif polymérisable est dans la gamme de 10:1 à 1:10 en poids.

18. Matériau photosensible de formation d'image selon l'une quelconque des revendications précédentes, dans lequel le liant est un dérivé cellulosique, un ester polyacrylique ou un ester polyméthacrylique.

19. Matériau photosensible de formation d'image selon l'une quelconque des revendications précédentes, dans lequel le monomère adhésif polymérisable est un composé ayant une double liaison acrylique ou méthacrylique.

20. Matériau photosensible de formation d'image selon la revendication 19, dans lequel le monomère adhésif polymérisable est un composé ayant dans sa molécule deux ou plusieurs liaisons doubles acryliques ou méthacryliques.

FIG.1

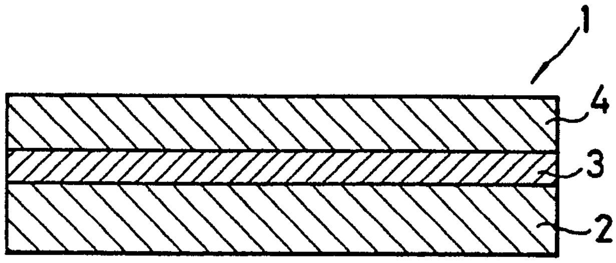


FIG.2A

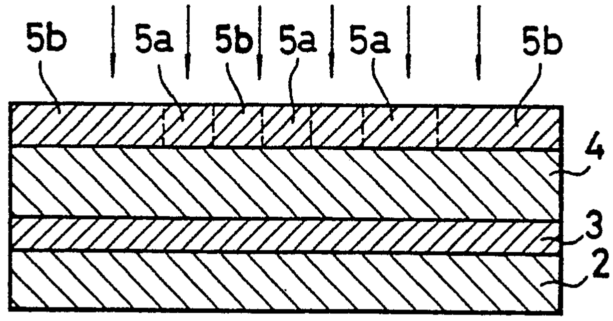


FIG.2B

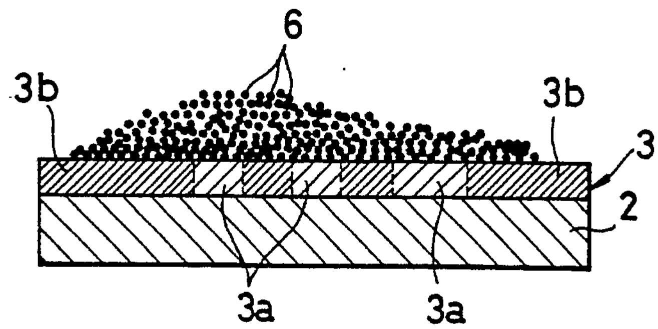


FIG.2C

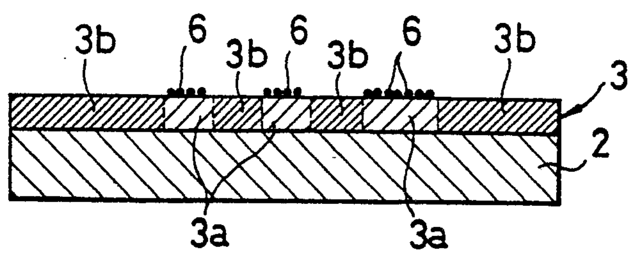

FIG.3

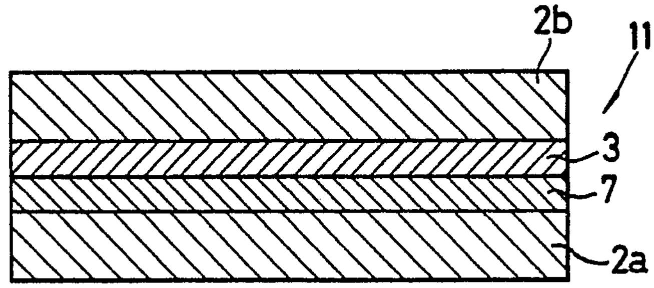


FIG.4A

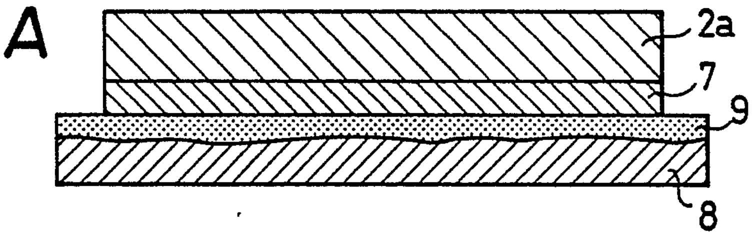


FIG.4B

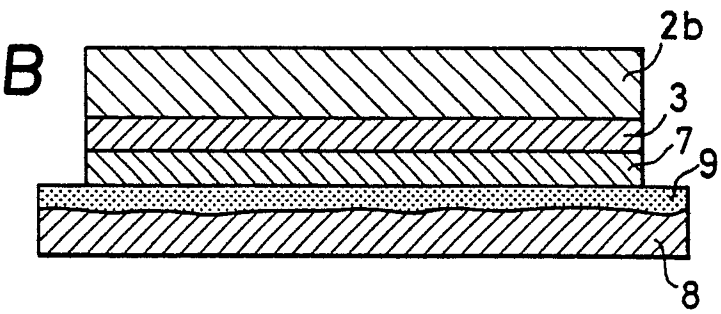


FIG.5A

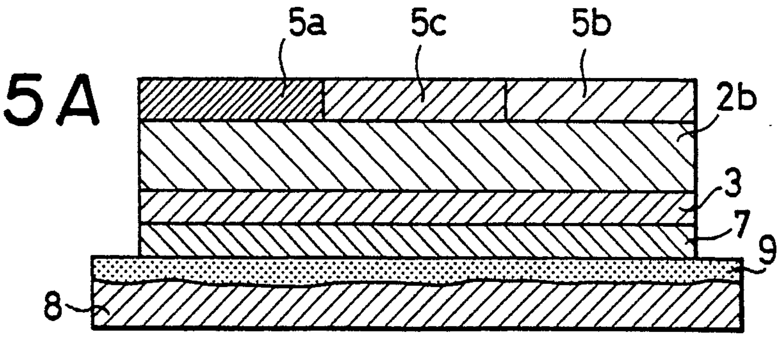

# FIG. 5B

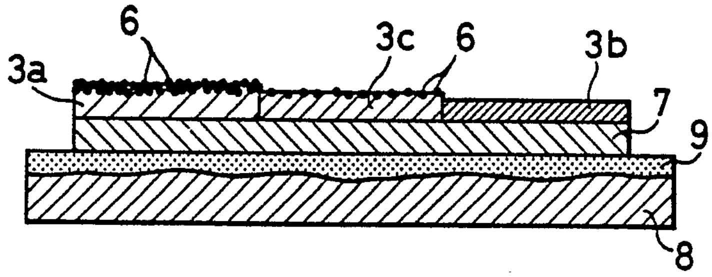
6
3a
3c
6
3b
7
9
8

# FIG. 6

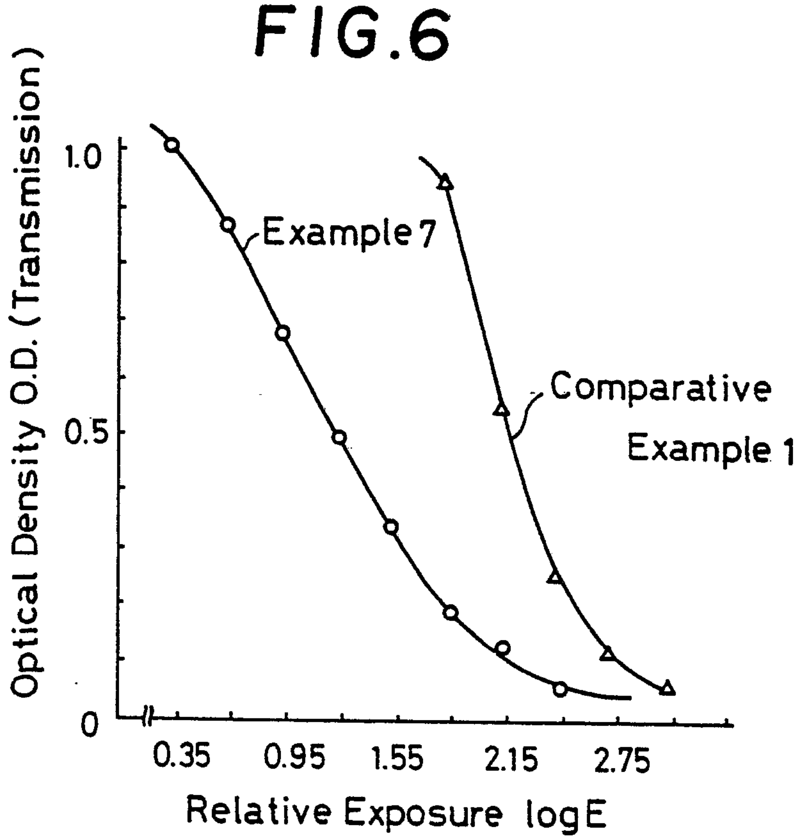
Optical Density O.D. (Transmission)
1.0
0.5
0
Example 7
Comparative
Example 1
0.35
0.95
1.55
2.15
2.75
Relative Exposure logE

FIG.7

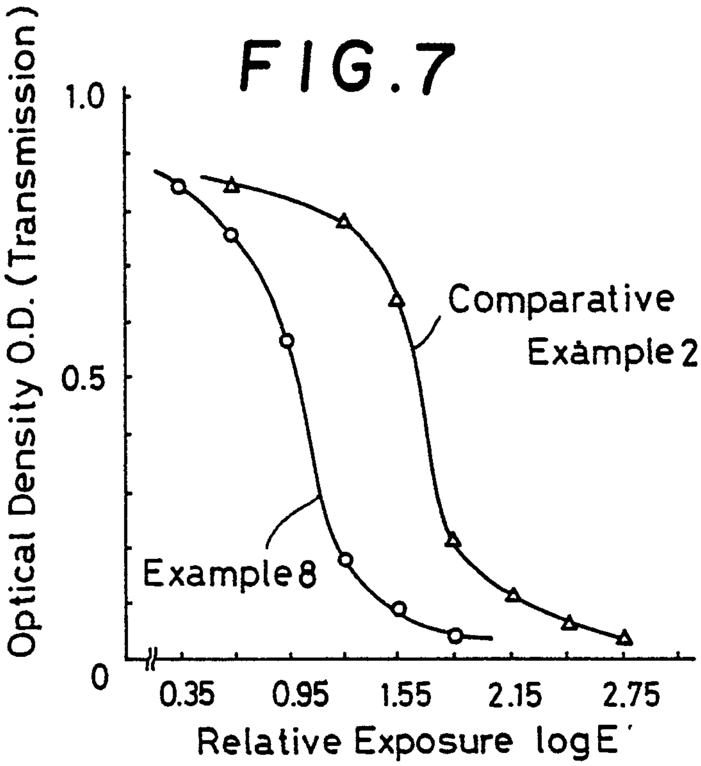
Optical Density O.D. (Transmission)
1.0
0.5
0
Comparative Example 2
Example 8
0.35
0.95
1.55
2.15
2.75
Relative Exposure logE

FIG.8

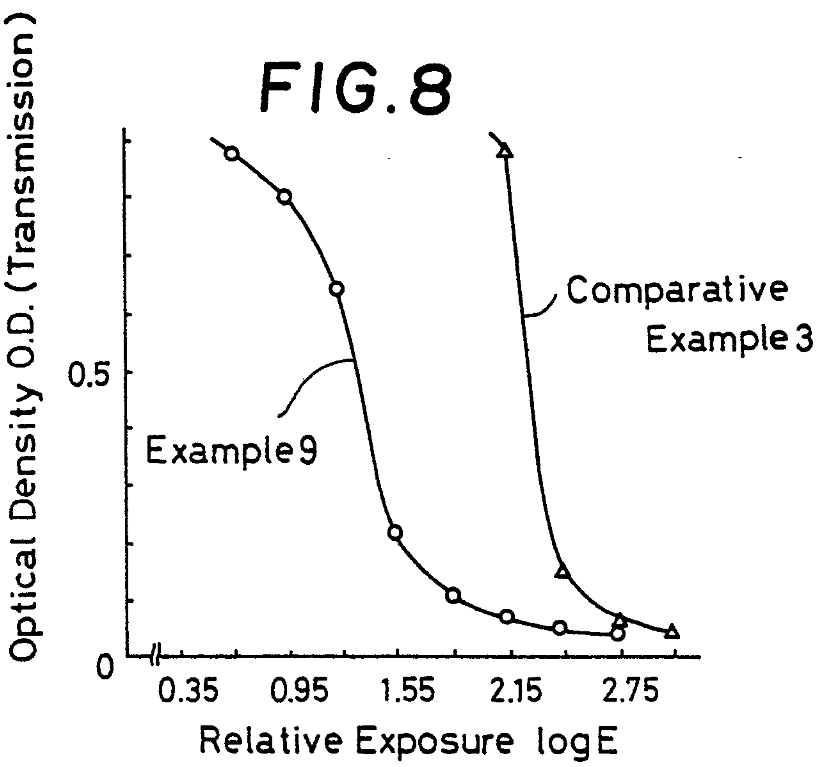
Optical Density O.D. (Transmission)
0.5
0
Comparative Example 3
Example 9
0.35
0.95
1.55
2.15
2.75
Relative Exposure logE

FIG.9

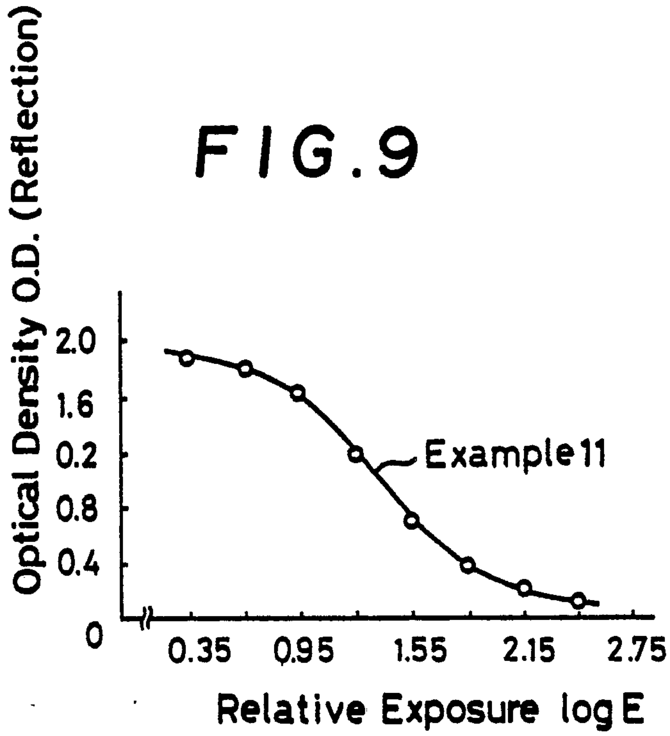
Optical Density O.D. (Reflection)
2.0
1.6
0.2
0.8
0.4
0
Example 11
0.35
0.95
1.55
2.15
2.75
Relative Exposure log E

FIG.10

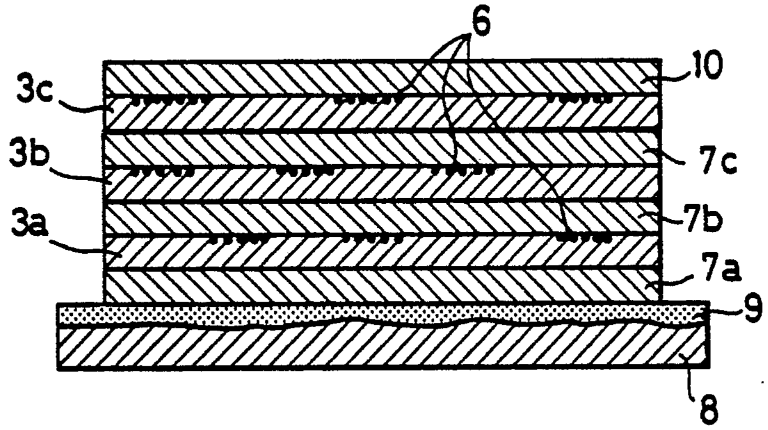
6
10
3c
3b
7c
3a
7b
7a
9
8